# EUROPEAN PATENT APPLICATION

(11) **EP 1 391 935 A2**
(43) Date of publication of application: **25.02.2004**
(21) Application number: 03014641.9
(22) Date of filing: 26.06.2003
(51) Int. Cl.: H01L 27/15, H01L 51/20

(54) **Color display unit**

(30) Priority: 27.06.2002 JP 2002187996
(71) Applicant: Kabushiki Kaisha Toyota Jidoshokki, Kariya-shi, Aichi-ken (JP)
(72) Inventor: Kato, Yoshifumi, Kariya-shi, Aichi-ken (JP)
(74) Representative: Leson, Thomas Johannes Alois, Dipl.-Ing.

(57) **Abstract**

A color display unit has a substrate, an organic electroluminescent device, a passivation film and a color filter. The organic electroluminescent device is located on the substrate. The organic electroluminescent device has an electroluminescent layer composed of organic electroluminescent material. The passivation film covers the organic electroluminescent device so that the electroluminescent layer is not exposed to the outside air. The color filter is located on the passivation film.

## Description

### BACKGROUND OF THE INVENTION

The present invention relates to a color display unit, and more particularly, to a color display unit that uses an organic light emitting diode (OLED) and has a light emitting layer containing an organic electroluminescent material.

Recently color display units using OLED attract attention for their superior display performance. However, methods for manufacturing OLED display devices, in which light emitting layers are formed for each of red, green, and blue, are complicated, resulting in high production cost. Further, it is difficult to produce such display units with high resolution or into large area.

In order to solve the problem, a color display unit having only a white light emitting layer is suggested. In this case, desired display colors are obtained by using a color filter.

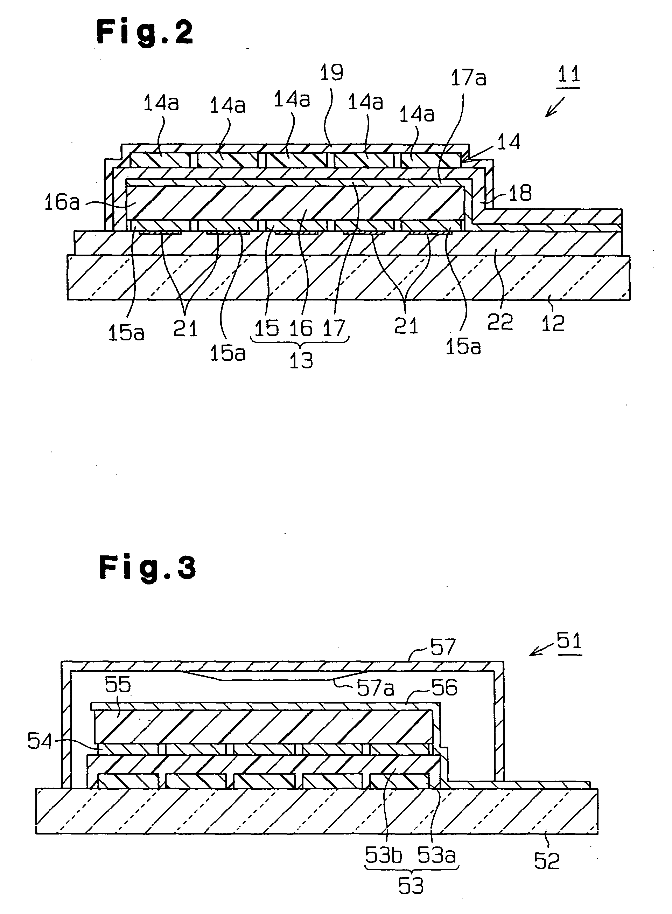

Referring to Fig. 3, a color display unit 51 has a color filter structure 53 which has color filter elements 53a and a planarization film 53b formed over a glass substrate 52. An anode 54, an organic electroluminescent layer 55 and a cathode 56 are laminated over the color filter structure 53 in succession. A shielding cover 57 for covering these is adhered to the substrate 52. The shielding cover 57 is located to shield the organic electroluminescent layer 55 from ambient air, since the organic electroluminescent layer 55 is reactive to oxygen and moisture. A gettering material 57a is accommodated within the shielding cover 57. The gettering material 57a refers to a substance that is disposed for absorbing components, such as moisture and oxygen which degrades the organic electroluminescent layer 55. An absorbent, a desiccant, or an oxygen absorbent or the like is used solely or in combination.

However, the color filter elements 53a generally contain an organic pigment. The organic pigment and/or a transparent resin in which the pigment is dispersed contain moisture. Further, the planarization film 53b disposed over the color filter elements 53a also contains moisture. Accordingly, the organic electroluminescent layer 55 is degraded by trace amount of moisture and oxygen that are released from the color filter structure 53 and that penetrated into the organic electroluminescent layer 55.

When forming color filter elements, pixels corresponding to R (red), G (green), and B (blue) must be colored separately, which creates steps (projections and depressions). To flatten the steps, a resin planarization film is formed over the color filters. However, the color filter elements and the planarization film are thicker than the organic electroluminescent layer. Therefore, microscopically, the surface of the planarization film is undulated. As a result, in a color filter elements having an organic electroluminescent elements formed on a planarization film coating color filters, an anode and a cathode, between which the thin electroluminescent layer is located, can be shortcircuited. This degrades the liability and reduces yields.

In active matrix display units, it is necessary to form a thin film transistor (TFT) drive circuit over the color filter structure 53. However, heat generated from the thin film transistors damages the color filter structure 53.

### SUMMARY OF THE INVENTION

Accordingly, it is a first objective of the present invention to provide a color display device, in which degradation of an organic electroluminescent layer due to moisture and gas components that occur from the color filter when an organic color filter is used, is reduced. A second objective of the present invention is to provide a color display device using the active matrix system, which prevents color filters from being adversely influenced by forming of TFT drive circuits.

To achieve the above objective, the present invention provides a color display unit having a substrate, an organic electroluminescent device, a passivation film and a color filter. The organic electroluminescent device is located on the substrate. The organic electroluminescent device has an electroluminescent layer composed of organic electroluminescent material. The passivation film covers the organic electroluminescent device so that the electroluminescent layer is not exposed to the outside air. The color filter is located on the passivation film.

Other aspects and advantages of the invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1(a) is a cross-sectional view illustrating an organic electroluminescent display device according to a first embodiment;
Fig. 1(b) is a diagrammatic view showing pixels;
Fig. 2 is a cross-sectional view illustrating an organic electroluminescent display device according to a second embodiment; and
Fig. 3 is a cross-sectional view illustrating a prior art organic electroluminescent display device.

### DETAILED DESCRIPTION OF THE PREFERRED EMBODIMENTS

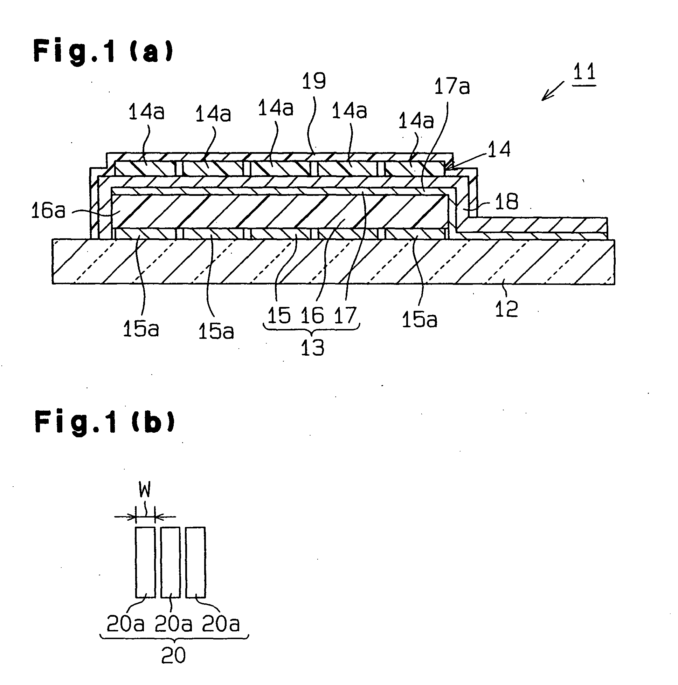

A passive matrix type organic electroluminescent color display unit 11 according to a first embodiment of the present invention will now be described with reference to Figs. 1(a) and 1(b). Fig. 1(a) is a cross-sectional view illustrating the organic EL color display unit 11.

As shown in Fig. 1(a), the organic electroluminescent color display unit 11 includes an organic electroluminescent device 13 and a color filter 14. The organic device 13 is formed on a substrate 12, and the color filter 14 is located at the opposite side of the organic device 13 from the substrate 12.

The organic electroluminescent device 13 is formed of a first electrode layer 15, an organic electroluminescent layer 16, and a second electrode layer 17, which are laminated in this order on the substrate 12. The first electrode layer 15 functions as electrodes at the substrate 12. The electroluminescent layer 16 contains organic electroluminescent material. The second electrode layer 17 functions as an electrode located farther from the substrate 12. The first electrode layer 15 includes first electrodes 15a, which are parallel each other. The second electrode layer 17 includes second electrodes 17a. The second electrodes 17a are parallel each other and extend in a direction perpendicular to the first electrodes 15a. The electroluminescent layer 16 includes electroluminescent elements 16a. The electroluminescent elements 16a of the electroluminescent layer 16 are formed at the intersections of the first electrodes 15a and the corresponding second electrodes 17a. The intersections are arranged in matrix. In this embodiment, the first electrode layer 15 functions as an anode, and the second electrode layer 17 functions as a cathode. The organic electroluminescent device 13 is coated with a passivation film 18 at least at the side opposite from the substrate 12, so that the electroluminescent layer 16 is not exposed to the outside air. The passivation film 18 is formed of a material that does not allow water to penetrate, such as silicon nitride SiNx or silicon oxide SiOx.

The color filter 14 includes color filter elements 14a, which are parallel each other. The color filter 14 is formed on the passivation film 18. That is, the color filter 14 is located at opposite side of the organic EL device 13 from the substrate 12. The passivation film 18 is located between the color filter 14 and the organic EL device 13. The color filter 14 is coated with a mar-proof protective film 19 at the side opposite from the side facing the passivation film 18. The protective film 19 is formed of, for example, an ultraviolet curing acrylic resin.

The first electrode layer 15 is formed of chromium. The first electrode layer 15 extends in a direction perpendicular to the elevation of Fig. 1(a). The electroluminescent layer 16 is formed of parallel stripes that are separated with insulating walls (not shown) and are arranged perpendicular to the first electrode layer 15.

The second electrode layer 17 is laminated on the electroluminescent layer 16. The second electrode layer 17 is formed of a transparent conductive material to permit light emission of the electroluminescent layer 16. In other words, the second electrode layer 17 is light transmittance type. Light is emitted to the outside through the second electrode layer 17. In this embodiment, the second electrode layer 17 is formed of indium tin oxide (ITO).

The electroluminescent layer 16, for example, has a conventional configuration. The electroluminescent layer 16 has a hole injection layer, an illuminating layer, an electron injection layer, which are arranged in this order from the side facing the first electrode layer 15. The electroluminescent layer 16 is formed so as to emit white light. The electroluminescent layer 16 forms pixels 20, which is shown in Fig. 1(b). Each pixel 20 forms three sub-pixels 20a. Each sub-pixel 20a corresponds to one intersection of the first electrodes 15a and the second electrodes 17a.

The color filter 14 is organic color filter. The color filter 14 has three types of pixels R (red), G (green), and B (blue). Each of the pixels R, G, B corresponds to one of the sub-pixels 20a of the corresponding pixel 20.

When manufacturing the organic electroluminescent color display unit 11, the substrate 12 is placed in an inert atmosphere (for example, in nitrogen gas), and the organic electroluminescent device 13 is formed on the substrate 12. The passivation film 18 is formed over the organic electroluminescent device 13. Then, the color filter element 14 is formed on the passivation film 18. That is, the color filter element 14 corresponds to the electroluminescent device 13 with the passivation film 18 in between. The ultraviolet curing acrylic resin is applied to coat the entire color filter element 14. Then, ultraviolet rays are applied to cure the resin, so that the color filter element 14 is coated with the protective layer 19.

The operations of the organic electroluminescent color display unit 11, which is constructed as above, will hereafter be described.

The first and second electrode layers 15, 17 are connected to a drive device. When voltage is applied to the electrodes 15, 17 that correspond to sub-pixels 20a to emit light, those sub-pixels 20a emit white light. White light from the sub-pixels 20a penetrates the second electrode layer 17, the passivation film 18, and the color filter 14, and is emitted from the protective layer 19. After white light penetrates the color pixels R, G, B of the color filter 14, the light is colored. A desired color is reproduced by combination of the color pixels R, G, and B.

In the prior art, the organic electroluminescent layer 55 is formed continuously on the color filter elements 53a via the planarization film 53b in between. Thus, water and gas (mainly oxygen) generated at the color filter elements 53a or the planarization film 53b degrade the organic electroluminescent layer 55. However, in this embodiment, the passivation film 18 is located between the organic electroluminescent device 13 and the color filter 14. This prevents water and gas generated at the color filter 14 from degrading the electroluminescent layer 16.

The organic electroluminescent color display unit 11 of the above embodiment and the organic electroluminescent color display unit 51 (comparison example) shown in Fig. 3 were compared. Specifically, deterioration of one of the pixels 20 over time was compared to that of the comparison example. That is, the degree of the phenomena in which each sub-pixel 20a deteriorates from the periphery (creation of dark areas) was examined referring to changes of the width W of light emitting area of each sub-pixel 20a. The results are shown in Chart 1.

| Chart 1 | | | |
|---|---|---|---|
| | Light Emitting Width | | Rate of Decrease |
| | Initially | After 1000 hrs in Room Temp. | |
| Embodiment | 96 | 87 | 9.4 |
| Comparison Ex. | 92 | 62 | 32.6 |

In the embodiment, the dark area expanded slowly after 1000 hours' exposure to a room temperature, and the light-emitting width W was sufficient. In the comparison example, due to the influence of water from the color filters or the planarization film, the organic electroluminescent layer 55 degraded, which expanded the dark area and significantly reduced the light emitting width W. In the embodiment, the rate of decrease of the light-emitting width W was approximately 9%. In the comparison example, the rate of decrease of the light-emitting width W was approximately 33%.

This embodiment provides the following advantages.
(1) The organic electroluminescent device 13 having the electroluminescent layer 16 is formed on one side of the substrate 12. The electrode layers 15, 17 are provided with the electroluminescent layer 16 in between. The second electrode layer 17, which is located at the opposite side of the electroluminescent layer 16 from the substrate 12, permits C light to pass through. That is, light is emitted from the second electrode layer 17. The organic electroluminescent device 13 is coated at least at the side opposite from the substrate 12. The electroluminescent layer 16 is coated with the passivation film 18 so that the electroluminescent layer 16 is not exposed to the outside air. The color filter 14 is formed on the passivation film 18. Therefore, unlike the prior art structure in which the color filter elements 53a are located between the organic electroluminescent layer 55 and the substrate 52 as shown in Fig. 3, the organic electroluminescent device 13 does not directly contact the color filter 14, but the passivation film 18 exists between the organic electroluminescent device 13 and the color filter 14. As a result, the electroluminescent layer 16 is prevented from being degraded by trace amounts of water or gas such as oxygen from the color filter 14. Also, the organic electroluminescent device 13 is formed flat. Therefore, even if the electroluminescent layer 16 is thin, the probability of short circuits between the electrode layers 15, 17 is reduced, and the reliability is improved. Further, no planarization film for flattening the surfaces of the color filter 14 is needed, which reduces the costs.
(2) The color filter 14 is formed directly on the passivation film 18. Therefore, compared to a case where there is a space between the passivation film 18 and the color filter 14, light does not leak from one pixel to nearby pixels. Therefore, colors are prevented from being blurred and are clearly reproduced.
(3) The color filter 14 is coated with the mar-proof protective film 19 at least at the side that does not face the electrodes of the color filter 14. Therefore, no foreign object directly contacts the color filter 14, and the color filter 14 is prevented from being damaged.
(4) The white light emitting layers are used. Therefore, the three primary colors of light are obtained by using red, green, and blue filter elements for the color filter 14. Thus, compared to a case in which light other than white light (for example, blue light) is used and a required color is obtained using color changing layers, the structure of the color filter 14 is simple.
(5) The color filter 14 is an organic color filter. Therefore, compared to a case where an inorganic color filter is used, the reproducibility of colors is improved.
(6) The direction in which light is emitted from the organic electroluminescent layer 16 (emitting direction) is opposite the substrate 12. Therefore, the substrate 12 and the first electrode layer 15 need not be transparent. This adds to the degree of flexibility in selecting materials for the unit 11.
(7) The first electrode layer 15, which is formed on the substrate 12, is formed of metal (in this embodiment, chromium). Therefore, compared to a case where the first electrode layer 15 is formed of transparent material, light from the organic electroluminescent layer 16 toward the substrate 12 is efficiently reflected by the first electrode layer 15. Accordingly, the amount of light that is emitted from the second electrode layer 17 is increased.
(8) The protective film 19 is formed of an ultraviolet curing acrylic resin. Therefore, the light transmittance of the protective film 19 is improved. Also, compared to a case where the protective film 19 is formed of a thermosetting resin, smaller amount of heat is applied to the color filter 14 when forming the protective film 19. This prevents the color filter 14 from being degraded or damaged by heat.
   A second embodiment of the present invention will now be described with reference to Fig. 2. The basic structure of the second embodiment is the same as that of the first embodiment. Unlike the first embodiment, the second embodiment is an active matrix type and has active drive elements, which are thin film transistors (TFT). Like or the same reference numerals are given to those components that are similar to or the same as the corresponding components of the first embodiment.
   A circuit layer 22 is formed on the substrate 12. The circuit layer 22 includes thin film transistors 21 functioning as active drive elements. The thin film transistors 21 correspond to the sub-pixels 20a of the organic electroluminescent device 13. In this embodiment, first electrode layer 15, which is located close to the substrate 12 and forms the organic electroluminescent device 13, is formed in matrix to cover the thin film transistors 21. The second electrode layer 17 does not include strips of electrodes, but is formed flat to cover the entire the electroluminescent layer 16.
   In this embodiment, the circuit layer 22, which includes the thin film transistors 21, is formed. Then, the organic electroluminescent device 13, which is the same as that in the first embodiment, is formed on the circuit layer 22. That is, unlike conventional active matrix type organic electroluminescent elements, the circuit including the thin film transistors.21 is not formed on the color filter, but is formed on the substrate 12 and independent from the color filter 14.
   In addition to the same advantages (1) to (8) of the first embodiment , the organic electroluminescent color display unit 11 of the second embodiment has the following advantages.
(9) Since the organic electroluminescent device 13 is driven by an active matrix system, crosstalk is prevented. Therefore, when the number of pixels is increased, created images are clearer than a case where passive matrix configuration is used.
(10) Since the circuit including the thin film transistors 21 need not be formed on the color filter 14, the color filter 14 is not degraded or damaged by heat generated when the thin film transistors 21 are formed. Therefore, the circuit containing the thin film transistors 21 can be formed by a conventional method used for manufacturing an active matrix liquid crystal panel. That is, there is no need to provide a facility for preventing the color filter 14 from degraded or damaged by heat.
(11) Light of the organic electroluminescent device 13 is emitted from the side opposite from the substrate 12. Therefore, no arrangement is need for preventing regions of the organic electroluminescent device 13 from overlapping the regions of the thin film transistors 21. The pixel electrodes (first electrode layer 15), which are located close to the substrate 12 and form the organic electroluminescent device 13, cover the thin film transistors 21. Therefore, if the area of the substrate 12 is constant, the area of the organic electroluminescent device 13 is increased compared to a case where the organic electroluminescent device 13 is formed in the same plane as the thin film transistors 21.

It should be apparent to those skilled in the art that the present invention may be embodied in many other specific forms without departing from the spirit or scope of the invention. Particularly, it should be understood that the invention may be embodied in the following forms.

Instead of white light emitting layers, blue light emitting layers may be used as the electroluminescent layer 16. In this case, by using a color filter having color changing layers as the color filter 14, the color of light that passes through the color filter 14 is changed to colors corresponding to the color pixels of R, G, or B. Thus, as in a case in which white light emitting layer is used, required colors are obtained with a single color light emitting layer.

The protective film 19 need not be formed of an ultraviolet curing acrylic resin, but may be formed of any mar-proof transparent material. For example, the protective film 19 may be formed of silicone resin hardcoat material. Also, the material is not limited to those that are cured after being applied. The color filter 14 may be coated with a transparent film (for example, polyester film such as polyethylene terephthalate).

The protective film 19 may be replaced with a transparent glass cover or a transparent rigid resin cover that covers the color filter 14. However, compared to these cases, using the protective cover 19 reduces the thickness of the organic electroluminescent color display unit 11.

In a case where a transparent glass cover or a transparent rigid resin cover is used to cover the color filter 14, the cover may be fixed to the substrate 12 with sealing material so that the interior is sealed, and the interior may be filled with a getter agent. In this case, the organic electroluminescent device 13 is disconnected from the exterior by double structure, or the cover and the passivation film 18. Therefore, the organic electroluminescent device 13 is further less susceptible to outside air and water. The electroluminescent layer 16 is prevented from being degraded.

The protective film 19 may be omitted. As long as a case for accommodating the entire organic EL color display unit 11 or a transparent cover for covering a portion corresponding to the color filter 14 is provided, the color filter 14 is scarcely damaged.

Since the substrate 12 need not be transparent, the material of the substrate 12 may be formed of materials other than glass. For example, the substrate 12 may be formed of an opaque ceramics or metal. Compared to glass, an opaque ceramics or metal are less likely to be damaged. Further, the substrate 12 may be made of a flexible material such as resin.

The first electrode layer 15, which is located close to the substrate 12, may be made of a metal other than chromium (for example, aluminum). Alternatively, the first electrode layer 15 may be made of a ceramics or a transparent material such as ITO.

The electrode layers 15, 17, which form the organic electroluminescent device 13, may be formed of transparent conductive material, and the reflectance of the substrate 12 may be less than these metal electrode layers. The reflectance of the substrate 12 is set equal to less than 30%, preferably equal to or less than 10%. If the reflectance is equal to or less than 30%, the amount of reflected outside light is decreased in a case where the organic electroluminescent color display unit 11 is used outdoors. This improves the contrast. If the reflectance is equal to less than 10%, the contrast is further improved. The reflectance of the substrate 12 is equal to or less than 10% if its surface is black. The surface can be easily blackened through anodizing.

The first electrode 15a, which are located close to the substrate 12, may be cathodes, and the second electrode 17a, which are located opposite side of the electroluminescent layer 16, may be anodes.

The material of the passivation film 18 is not limited to silicon nitride SiNx or silicon oxide SiOx as long as the material is transparent and has a small permeability to water and gas such as oxygen. For example the passivation film 18 may be formed of a diamond like carbon. When any of these materials is used, the passivation film 18 is formed through vacuum film forming. The vacuum film forming refers to any method for forming a film in a lowered pressure or vacuum, such as vacuum evaporation, sputtering, ion plating, ion beam, and CVD. Particularly, when using silicon nitride SiNx, the passivation film 18 is manufactured in a temperature equal to or less than 100°C, this protects the electroluminescent layer 16 from damages during forming of the passivation film 18.

In the structure where the organic electroluminescent device 13 is driven through the active matrix system, the active drive elements and the organic electroluminescent device 13 may be located on the same plane of the substrate 12. That is, the active drive elements may be located adjacent to the organic electroluminescent device 13. Further, the electrodes closer to the substrate 12 (the first electrode layer 15) may cover part of the active drive elements.

Instead of the thin film transistors 21, metal-insulator-metal (MIM) elements may be used as the active drive elements.

The organic electroluminescent device 13 may be provided not only on one side of the substrate 12, but also on both sides of the substrate 12. That is, the organic electroluminescent device 13 may be on the side where no electroluminescent device 13 is provided in the illustrated embodiments, and the passivation film 18 and the color filter 14 may be formed on the electroluminescent device 13.

Therefore, the present examples and embodiments are to be considered as illustrative and not restrictive and the invention is not to be limited to the details given herein, but may be modified within the scope and equivalence of the appended claims.

A color display unit has a substrate, an organic electroluminescent device, a passivation film and a color filter. The organic electroluminescent device is located on the substrate. The organic electroluminescent device has an electroluminescent layer composed of organic electroluminescent material. The passivation film covers the organic electroluminescent device so that the electroluminescent layer is not exposed to the outside air. The color filter is located on the passivation film.

## Claims

1. A color display unit has a substrate, an organic electroluminescent device located on the substrate, wherein the organic electroluminescent device has an electroluminescent layer composed of organic electroluminescent material, a passivation film, which covers the organic electroluminescent device so that the electroluminescent layer is not exposed to the outside air, the color display unit being **characterized by**:
a color filter located on the passivation film.

2. The color display unit according to claim 1 further being **characterized by** a mar-proof protective film coating the color filter.

3. The color display unit according to claims 1 or 2, **characterized in that** the organic electroluminescent device has a first electrode and a second electrode, wherein the electroluminescent layer is located between the first and second electrodes, wherein the first electrode is located between the substrate and the electroluminescent layer, and wherein the second electrode is light transmittance type.

4. The color display unit according to claim 3, **characterized in that** an active drive element is located on the substrate, and wherein the first electrode covers at least part of the active drive element.

5. The color display unit according to claim 3 further being **characterized by** an active drive element, the active drive element being located on the substrate and on the same plane as the organic electroluminescent device.

6. The color display unit according to any one of claims 1 to 5, **characterized in that** the electroluminescent layer is white electroluminescent layer.

7. The color display unit according to any one of claims 1 to 5, **characterized in that** the electroluminescent layer is blue electroluminescent layer, and wherein the color filter has a color changing layer.

8. The color display unit according to any one of claims 1 to 7, **characterized in that** the light reflectance of the substrate is equal to or less than 30%.

9. The color display unit according to any one of claims 1 to 7, **characterized in that** the light reflectance of the substrate is equal to or less than 10%.

10. The color display unit according to any one of claims 1 to 9, **characterized in that** the color filter is formed of an organic material.
